# EUROPEAN PATENT SPECIFICATION

(11) **EP 2 770 005 B1**
(45) Date of publication and mention of the grant of the patent: **08.05.2019**
(21) Application number: 11874396.2
(22) Date of filing: 18.10.2011
(51) Int. Cl.: C08G 59/32, C08G 59/42, C08L 63/00, H05K 1/03

(54) **EPOXY RESIN COMPOSITION AND HIGH FREQUENCY ELECTRONIC-CIRCUIT SUBSTRATE MANUFACTURED BY USING THE SAME**
EPOXIDHARZZUSAMMENSETZUNG UND DAMIT HERGESTELLTES SUBSTRAT EINES ELEKTRONSICHEN HF-SCHALTKREISES
COMPOSITION DE RÉSINE ÉPOXY ET SUBSTRAT DE CIRCUIT ÉLECTRONIQUE HAUTE FRÉQUENCE FABRIQUÉ EN L'UTILISANT

(43) Date of publication of application: 27.08.2014
(73) Proprietor: Guangdong Shengyi Sci. Tech Co., Ltd, Dongguan, Guangdong 523808 (CN)
(72) Inventor: ZENG, Xianping, Dongguan Guangdong 523-808 (CN)
(74) Representative: Wallinger, Michael
(86) International application number: PCT/CN2011/080925
(87) International publication number: WO 2013/056419

(56) References cited:
- WO-A1-2008/044766
- JP-A- H08 176 274
- JP-A- 2003 002 949
- JP-A- 2007 045 984
- JP-A- 2009 001 757
- TW-A- 201 041 969
- US-A1- 2011 139 496

## Description

### Technical Field

The present invention relates to a resin composition, and in particular relates to an epoxy resin composition and a high frequency circuit board manufactured by using the same.

### Background Art

With the high speed and multifunction of the electronic information processing, and the continuously improvement of the application frequency, 3- 6GHz will become mainstream. In addition to maintaining a higher demand on the heat resistance of the laminate materials, the dielectric constant and dielectric loss value will demand lower and lower. Existing traditional FR-4 material is difficult to meet the needs of high-frequency and high-speed development of electronic products, while the substrate material is no longer a mechanical support role played in the traditional sense, rather, it will, together with electronic components, become an important way for PCB and terminal manufacturers designers to improve the product performance. High DK causes the signal transfer rate slow, and high Df causes the signal partly convert into heat loss in the substrate material, so reducing the DK / Df has become the hot pursuit of the substrate industry. Conventional FR-4 material mainly uses dicyandiamide as a curing agent. This curing agent has good process operability for a tertiary amine reaction, but due to high cracking at high temperatures for the weak carbon-nitrogen bond, which results the condensate has lower decomposition temperature and is unable to adapt to the heat requirements of lead-free processes. In this context, cyanate ester resin having excellent dielectric properties has become one of the hot high-profile. Nonetheless, cyanate ester resin has its own limitations, including poor wet-heat resistance and easiness of delamination at high temperature.

Japanese Patent Publication No. Sho 46-41112, Laid-Open Patent Publication No. Sho 50-132099 and Laid-Open Patent Publication No. Sho 57-143320 propose a scheme, in which common used epoxy resins such as bisphenol A epoxy resin, brominated bisphenol A epoxy resin, phenol novolac epoxy resin and phenol novolac cresol epoxy resin are mixed with cyanate ester resin to form a resin composition. The resin composition further improves wet-heat resistance compared with cyanate ester unitary system, but greatly determines dielectric properties of cyanate ester resin due to influence of epoxy resin. Thus, in Japanese Patent Laid-Open Publication No. 8-176273, JP Patent Publication No. 8-176274 and Patent Publication No. 11-60692 propose to select specific epoxy resin such as naphthalene ring-containing epoxy resin, biphenyl structure-containing epoxy resin, lower alkyl-substituted phenol salicylaldehyde novolac epoxy resin, and dicyclopentadiene-containing epoxy resin to mix with cyanate ester resin. This mixture improves dielectric properties compared with common used epoxy resin composition, but greatly reduces glass transition temperature due to reduction of crosslinking density of the epoxy resin. US2011/0139496 A1 discloses a resin composition comprising a cyanate ester, a naphthylene ether type epoxy resin, and an active ester curing agent.

### Summary

One object of the present invention is to provide an epoxy resin composition, which can provide excellent dielectric properties, wet-heat resistance and high glass transition temperature required by high-frequency circuit substrate.

Another object of the present invention is to provide a high-frequency circuit board having excellent dielectric properties and wet-heat resistance and having high glass transition temperature at the same time which is manufactured by using the above-mentioned epoxy resin composition.

To achieve the above objects, the present invention provides an epoxy resin composition as defined in claim 1, comprising the following solid components:
((A) cyanate ester compound having at least two cyanato groups or its pre-polymer,
(B) active ester, and
(C) epoxy resin containing naphthol structure;
based on the parts by weight of the solid components, the total usage of the component (A) cyanate ester compound having at least two cyanato groups or its pre-polymer and the component (B) active ester is 30-90 parts by weight, wherein the weight ratio between the component (A) cyanate compound having at least two cyanoxy groups or its pre-polymer and the component (B) active ester is 0.2-5: 1.

The component (A) cyanate compound having at least two cyanato groups or its pre-polymer includes at least one cyanate ester compound having the following structural formula or its pre-polymer: 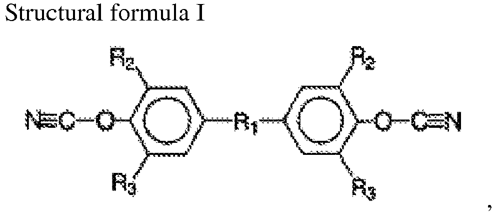 -CH2-, wherein R1 represents 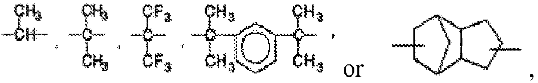 R2 and R3 may be same or different, each represents hydrogen atom or alkyl group having 1 to 4 carbon atoms; 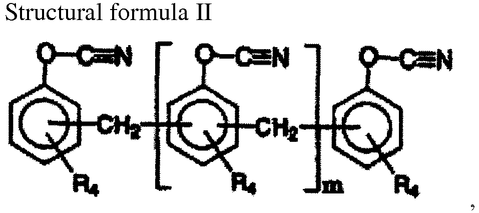 wherein R4 represents hydrogen atom or alkyl group having 1-4 carbon atoms and m is an integer of 1-7.

The component (A) cyanate ester compound containing at least two cyanato groups in the molecule or its prepolymer is one or more selected from the group consisting of 2,2-bis (4-cyano-phenyl) propane, bis (4-cyano-phenyl)ethane, bis(3,5-dimethy-4-cyanatophenyl)methane, 2,2-bis (4-cyano-phenyl)-1,1,1,3,3,3-hexafluoropropane, α,α'-bis(4-cyano-phenyl)-1,3-bis(isopropyl)benzene, cyclopentadiene cyanate, phenol novolac cyanate and cresol novolac cyanate, or prepolymer thereof. Preferably, the component (A) cyanate ester compound containing at least two cyanato groups in the molecule or its prepolymer is one or more selected from the group consisting of2,2-bis (4-cyano-phenyl) propane, bis(3,5-dimethy-4-cyanatophenyl)methane and α,α'-bis(4-cyano-phenyl)-1,3-bis(isopropyl)benzene, or prepolymer thereof.

The component (B) active ester includes active ester of the following structural formula: 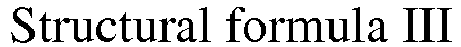 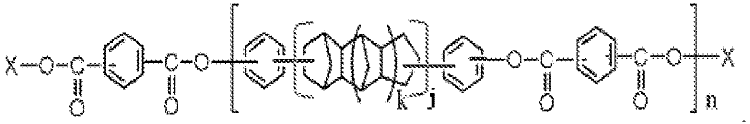 wherein
X is benzene ring or naphthalene ring,
j is 0 or 1,
k is 0 or 1,
n means the average repeating unit and is 0.25-1.25.

The component (C) epoxy resin containing naphthol structure has the following structural formula: 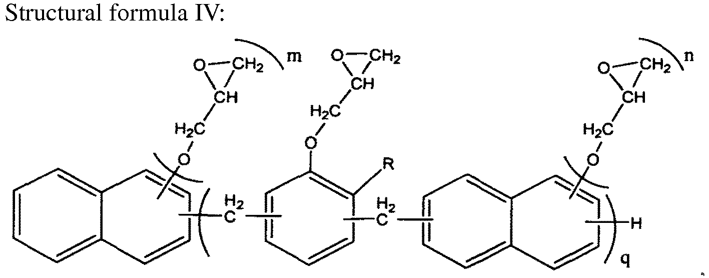
wherein m and n are 1 or 2 respectively,
q is an integer between 1 and 10,
R is H or alkyl group having 1-5 carbon atoms.

The epoxy resin composition further comprises a flame retardant, wherein the flame retardant is mixed preferably in 5-100 parts by weight based on 100 part by weight of the sum of component (A), component (B) and component (C); the flame retardant is a bromine-containing flame retardant or a non-halogen flame retardant, wherein the bromine-containing flame retardant is selected from decabromodiphenyl ether, decabromodiphenyl ethane, brominated styrene or ethylenebistetrabromophthalimide, and the non-halogen flame retardants is selected from tri(2,6-dimethyphenyl)phosphine, 10-(2,5-dihydroxyphenyl)-9,10-dihydrogen-9-oxa-10-phosphenanthrene- 10-oxide, 2,6-bis(2,6-dimethylphenyl) phosphenyl, 10-phenyl-9, 10-dihydrogen-9-oxa-10-phosphenanthrene- 10-oxide, phenoxy phosphonic cyanide compounds or zinc borate.

The epoxy resin composition further comprises an inorganic filler, the filler is mixed preferably in 5-500 parts by weight based on 100 parts by weight of the sum of component (A), component (B) and component (C), wherein the inorganic filler is one or more selected from the group consisting of crystalline silica, fused silica, spherical silica, aluminum nitride, boron nitride, titanium oxide, strontium titanate, barium titanate, alumina, barium sulfate, talc powder, calcium silicate, calcium carbonate, mica, and polytetrafluoroethylene; and wherein the particle size of the inorganic filler is 0.01-50 µm.

At the same time, the present invention also provides a high-frequency circuit board manufactured by using the above-mentioned epoxy resin composition, comprising several stacked prepregs and copper foils cladded on both sides of the stacked prepregs, wherein the prepregs all include the epoxy resin composition adhering thereon by impregnating and then drying.

The high frequency electronic-circuit board is prepared by cladding the copper coil on both sides of the stacked prepregs and curing in a hot press machine, wherein the curing temperature is 150-250°C and the curing pressure is 25-60 Kg/cm².

The present invention has the following beneficial effects:
① the epoxy resin composition of the present invention use cyanate ester and active ester as compound curing agents, achieving the advantages of high glass transition temperature and good dielectric properties of cyanate ester, and overcoming the defect of poor wet-heat resistance;
② the epoxy resin composition of the present invention use cyanate ester and active ester as curing agents, fully achieving the advantages of excellent dielectric properties and good wet-heat resistance due to the fact that no polar hydroxyl group is generated in the reaction between active ester and epoxy resin; and use a epoxy resin containing specific naphthol structure, further reducing water absorption of cured resin, and addressed the disadvantage of relatively low glass transition temperature;
③ the epoxy resin composition of the present invention also comprises epoxy resin having at least one naphthol structure, wherein the naphthol group in the epoxy resin presents hydrophobic property and high rigidity, and thus the circuit board manufactured by using epoxy resin composition and the above-mention compound curing agents can further optimize dielectric properties and have high glass transition temperature after curing;
④ the high-frequency circuit board manufactured by using the above-mentioned epoxy resin composition of the present invention has excellent dielectric properties and wet-heat resistance, and has high glass transition temperature at the same time.

### Detailed Description

The epoxy resin composition of the present invention includes the following solid components:
(A) cyanate ester compound having at least two cyanato groups or its pre-polymer,
(B) active ester as defined in claim 1, and
(C) epoxy resin containing naphthol structure as defined in claim 1; based on the parts by weight of the solid components, the total usage amount of the component (A) cyanate ester compound having at least two cyanato groups or its pre-polymer and the component (B) active ester is 30-90 parts by weight, wherein the weight ratio between the component (A) cyanate compound having at least two cyanoxy groups or its pre-polymer and the component (B) active ester is 0.2-5: 1.

There is no limitation on the component (A) cyanate ester compound having at least two cyanato groups in the molecule. As long as the molecule has at least two cyano groups in the molecule, it can conduct crosslinking to be cured. The cyanate compound having at least two cyanato groups in the molecule can include at least one cyanate ester compound having the following structural formula or its pre-polymer: 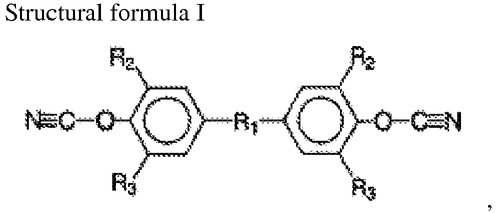 -CH2-, wherein R1 represents 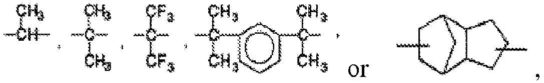 R2 and R3 may be same or different, each represents hydrogen atom or alkyl group having 1 to 4 carbon atoms; 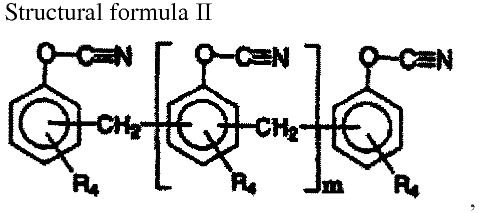 wherein R4 represents hydrogen atom or alkyl group having 1-4 carbon atoms and m represents an integer between 1 and 7.

The cyanate ester compound having at least two cyanato groups in the molecule of component (A), forms cyanate ester oligomer having thiotriazinone. There is no special limitation on the conversion of cyanato in the oliogomer. The oliogomer can be prepolymer of the cyanate ester compound having structural formula I or II. The component (A) cyanate ester compound containing at least two cyanato groups in the molecule or its prepolymer is one or more selected from the group consisting of 2,2-bis (4-cyano-phenyl) propane, bis (4-cyano-phenyl)ethane, bis(3,5-dimethy-4-cyanatophenyl)methane, 2,2-bis(4-cyano-phenyl)-1,1,1,3,3,3-hexafluoropropane, α,α'-bis(4-cyano-phenyl)-1,3-bis(isopropyl)benzene, cyclopentadiene cyanate, phenol novolac cyanate and cresol novolac cyanate, or prepolymer thereof. Preferably, the component (A) cyanate ester compound containing at least two cyanato groups in the molecule or its prepolymer is one or more selected from the group consisting of2,2-bis (4-cyano-phenyl) propane, bis(3,5-dimethy-4-cyanatophenyl)methane and α,α'-bis(4-cyano-phenyl)-1,3-bis(isopropyl)benzene, or prepolymer thereof. These compounds can be used alone or in combination.

The component (B) of the present invention is an active ester containing specific structure. The ester group conducts a curing reaction with epoxy resin without generating polar group -OH, thus wet resistance and dielectric properties are good.

The structural formula is represented as follows: 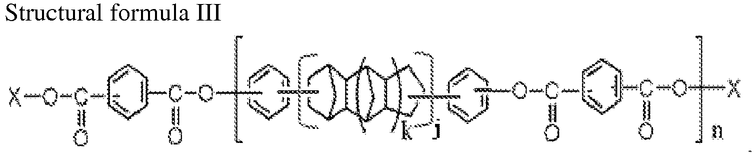 wherein
X is benzene ring or naphthalene ring,
j is 0 or 1,
k is 0 or 1,
n means the average repeating unit and is 0.25-1.25.

The specific rigid structures in the active ester such as benzene ring, naphthalene ring, cyclopentadiene render it high wet resistance; the structural orderliness of the active ester render it good dielectric properties.

The epoxy resin composition of the present invention introduces the above-mentioned active ester, which forms compound curing agent together with the cyanate ester. Cyanate ester-modified epoxy resin has poor wet resistance mainly because of wet-heat decomposition of the thiotriazinone structure formed in curing and residual cyanate ester groups. Therefore, to resolve the wet-heat resistance problem, the two kinds of groups should be reduced. Nonetheless, thiotriazinone structure has unique advantages such as high glass transition temperature and good dielectric properties. Therefore, the cyanate ester and active the ester form compound curing agents together can reduce the ration of thiotriazinone to address the problem of poor wet-heat resistance, and improve both dielectric properties and wet-heat resistance, and overcomes the disadvantage of relatively low glass transition temperature. The weight ratio of the component (A) a cyanate compound having at least two cyanoxy groups in the molecule or its pre-polymer to the component (B) an active ester is 0.2-5 to 1, preferably 0.2-3: 1, more preferably 0.3-3: 1.

The component (C) epoxy resin containing naphthol has the following formula IV: 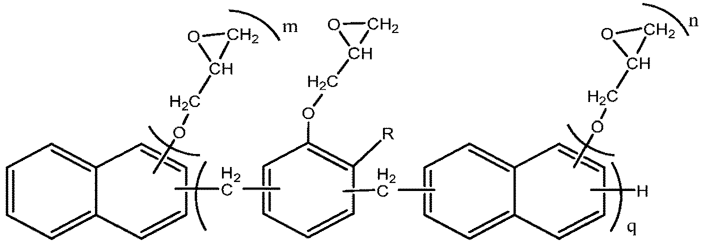
wherein m and n are 1 or 2 respectively,
q is an integer between 1 and 10,
R is H or alkyl group having 1-5 carbon atoms.

The above-mentioned component (C) epoxy resin containing naphthol structure can be the more specific following structural formulas: 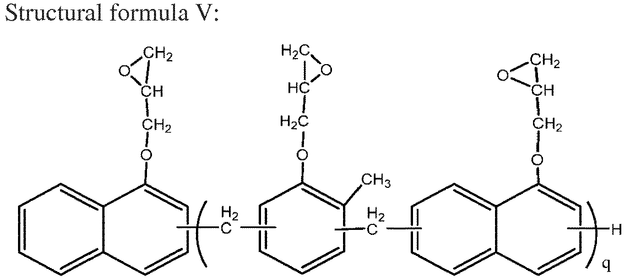 wherein q is an integer between 1 and 10;

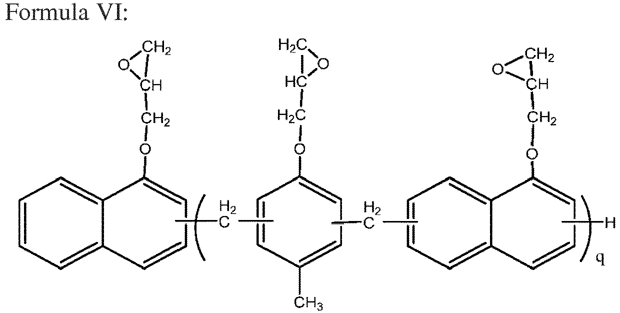

Wherein q is an integer between 1 and 10;or

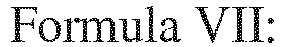

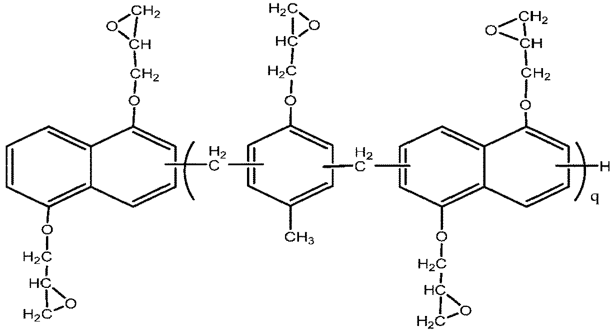

In the present invention, component C) is used in an amount of 30-90 parts by weight, preferably 40-90 parts by weight.

The above-mentioned epoxy resin composition can further comprise flame retardants, inorganic fillers and other additives as long as dielectric properties and heat resistance are not affected.

There is no specific limitation on the flame retardant added as needed. It is better to use non-reactive flame retardant and it is better without affecting dielectric properties. The flame retardant can be a bromine-containing flame retardant or a non-halogen flame retardant, wherein the bromine-containing flame retardant is selected from the group consisting of decabromodiphenyl ether, decabromodiphenyl ethane, brominated styrene or ethylenebistetrabromophthalimide, and the non-halogen flame retardants is selected from tri(2,6-dimethyphenyl)phosphine, 10-(2,5-dihydroxyphenyl)-9,10-dihydrogen-9-oxa-10-phosphenanthrene-10-oxide, 2,6-bis(2,6-dimethylphenyl) phosphenyl, 10-phenyl-9, 10-dihydrogen-9-oxa-10-phosphenanthrene- 10-oxide, phenoxy phosphonic cyanide compounds or zinc borate. The flame retardant is mixed in 5 to 100 parts by weight based on 100 parts by weight of the sum of component (A), component (B) and component (C); more preferably 5 to 90 parts by weight; particularlly preferably 5 to 80 parts by weight.

There is no specific limitation on the filler added as needed. The inorganic filler can be one or more selected from the group consisting ofcrystalline silica, fused silica, spherical silica, aluminum nitride, boron nitride, titanium oxide, strontium titanate, barium titanate, alumina, barium sulfate, talc powder, calcium silicate, calcium carbonate, mica, and polytetrafluoroethylene. In addition, there is no specific limitation on shape and particle size of the inorganic filler. The particle size of the inorganic filler is usually 0.01-50 um, preferably 0.01 to 20 um, particularly preferably 0.1 to 10 um. It is easier to disperse for this range of the particle size. Furthermore, there is no specificlimitation on the dosage of the filler. Preferably, the filler is used in 5-1000 parts by weight based on 100 parts by weight of the sum of component (A), component (B) and component (C), more preferably 5-800 parts by weight, particularly preferably 5-200 parts by weight.

The specific method for preparing high frequency circuit board by using the above-mentioned epoxy resin composition is as follows: to a container adding solid components and then liquid solvent, stirring till completely resolved, adding liquid resin, filler, flame retardant and accelerant, continually stirring evenly to obtain glue; impregnating glass fabric into the glue, control to a suitable thickness and dying to remove the solvent, thereby obtaining prepreg; ladding the copper coil on both sides of the stacked prepregs and curing in a hot press machine, wherein the curing temperature is 150-250°C and the curing pressure is 25-60 Kg/cm².

The high frequency circuit board manufactured comprises: several stacked prepregs and copper foils respectively cladded on both sides of the stacked prepregs, wherein the prepregs all include substrate and epoxy resin composition adhering thereon by impregnating and then drying. The substrate can use natural fiber, organic synthesis fiber, organic fabric and inorganic fiber, for example, glass fabric.

For high frequency circuit board made as mentioned above, dielectric constant, dielectric loss factor, glass transition temperature and wet-heat resistance are all measured, and further described referring to the following embodiments.

### Embodiment 1:

To a container were added naphthol novolac epoxy resin NC-7300L in 60 parts by weight, bisphenol A cyanate ester resin HF-10 in 18 parts by weight and HPC-8000-65T in 22 parts by weight. The mixture was stirred, then to it were added appropriate amount of accelerant zinc dioctanoate and DMAP in addition to the solvent toluene, obtaining a glue after stirring to uniformity. Glass fabric is impregnated into the glue solution, and are controlled to an appropriate thickness. Then the glass fiber cloth is dried to remove the solvent, thereby obtaining a prepreg. Several such prepregs are stacked, and two copper foils are cladded on both sides of the stacked prepregs, obtaining a high frequency circuit board in a hot press machine. Physical property data of the copper-clad laminate is shown in Table 1.

### Embodiments 2 to 4:

The manufacturing process is the same as that in embodiment 1. The formulas and physical property data is shown in Table 1.

### Comparison Example 1 to 3:

The manufacturing process is the same as that in tembodiment 1. The formulas and physical property data is shown in Table 1.

**Table1 Formulas and Physical Property Data of Embodiments and Comparative Examples**

| Component | Embodiment 1 | Embodiment 2 | Embodiment 3 | Embodiment 4 | Comparative Example 1 | Comparative Example 2 | Comparative Example 3 |
|---|---|---|---|---|---|---|---|
| NC-7300L | 60 | --- | --- | 60 | 60 | 50 | --- |
| NC-7000L | --- | 60 | --- | --- | --- | --- | --- |
| NC-7700L | --- | --- | 65 | --- | --- | --- | --- |
| HP-7200H | --- | --- | --- | --- | | --- | --- |
| N-690 | --- | --- | --- | --- | --- | --- | 60 |
| HF-10 | 22 | 20 | 22 | 20 | 1eq | | 1eq |
| PT-30 | --- | --- | --- | 20 | --- | --- | --- |
| HPC-8000-65T | 22 | 20 | 22 | 20 | 1eq | --- | 1eq |
| zinc dioctanoate | 0.015 | 0.015 | 0.015 | 0.015 | --- | 0.1 | --- |
| DMAP | 0.06 | 0.06 | 0.06 | 0.06 | 0.15 | --- | 0.2 |
| Tg(DMA)/°C | 210 | 215 | 220 | 230 | 170 | 230 | 160 |
| Dk(10g) | 3.7 | 3.8 | 3.8 | 3.8 | 3.8 | 3.8 | 3.85 |
| Df(10g) | 0.006 | 0.007 | 0.007 | 0.0075 | 0.0085 | 0.0009 | 0.0015 |
| PCT/2h | 3/3 | 3/3 | 3/3 | 3/3 | 3/3 | 1/3 | 2/3 |

The materials listed in the table are particularly as follows:
- NC-7300L:: naphthol novolac epoxy resin with epoxy equivalent of 214g/eq;
- NC-7000L:: naphthol novolac epoxy resin with epoxy equivalent of 232g/eq;
- NC-7700L:: naphthol novolac epoxy resin with epoxy equivalent of 233g/eq;
- HP-7200-H:: dicyclopentadiene novolac epoxy resin with epoxy equivalent: of 280g/eq;
- N-690:: o-cresol novolac epoxy resin with epoxy equivalent of 215g/eq;
- HF-10:: bisphenol A cyanate ester resin polymer;
- PT-30:: phenol formaldehyde cyanate;
- HPC-8000-65T:: active ester curing agent with active ester equivalent of 223g/eq;
- TD-2090:: linear novolac curing agent with hydroxyl group equivalent of 105g/eq;
- DMAP:: 4-dimethylaminopyridine.

The test method of the above properties is as follows:
(1) glass transition temperature (Tg): measured via the DMA assay prescribed in accordance with IPC-TM-650 2.4.24.
(2) dielectric constant and dielectric loss factor: measured according to SPDR method.
(3) wet-heat resistance evaluation after PCT: the substrate lamina was evaluated after the copper foil on the surface of copper-clad laminate was etched; the substrate lamina is placed in a pressure cooker, and treated at 120 ° C and under 105KPa for 2h; then the substrate lamina is impregnated in a tin furnace at 288 ° C; once the substrate lamina is delaminated, record the corresponding time; if no bubble or delamination occurred after the substrate lamina was in a tin furnace for 5min, the evaluation can be finished.

### Physical Properties Analysis

As can be known from the physical property data shown in table 1: for comparative examples 1 using the naphthol epoxy resin and being cured only by active ester, the dielectric properties are improved compared with common used epoxy resin, and the wet-heat resistance is good, but the glass transition temperature is low; for comparative example 2 having same structure and being cured by a cyanate resin, the glass transition temperature is high, and the dielectric properties is improved, but the wet-heat resistance is poor; for comparative example 3 using active ester as curing agent, the wet-heat resistance is good, but the dielectric properties are poor; for embodiments 1-4 co-cured using epoxy resin containing naphthol structure and active ester, the obtained cured product has better dielectric properties compared with common used novolac resin, and has high glass transition temperature and good wet-heat resistance.

In summary, compared with the common used copper-clad board, the high frequency circuit board of the present invention has more excellent dielectric properties, and has high glass transition temperature and good wet-heat resistance at the same time.

The above embodiments are merely preferred examples of the present invention.

Those skilled in the art can make numerous variations and changes according to the technical solution of the present invention, all of which fall into the protected scope prescribed by the claims of the present invention.

## Claims

1. An epoxy resin composition, comprising the following solid components:
(A) cyanate ester compound having at least two cyanato groups in the molecule or its pre-polymer,
(B) active ester, which comprises an active ester of the following structural formula: 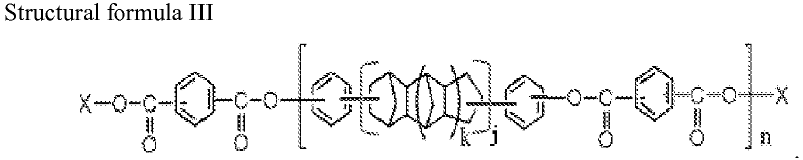 wherein
X is benzene ring or naphthalene ring,
j is 0 or 1,
k is 0 or 1,
n means the average repeating unit and is 0.25-1.25;and
(C) epoxy resin containing naphthol structure having the following structural formula: 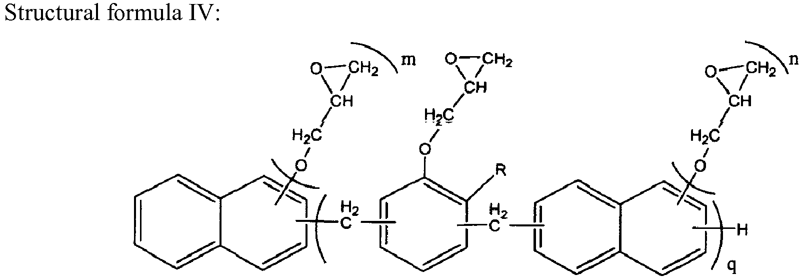
wherein m and n are 1 or 2 respectively,
q is an integer between 1 and 10,
R is H or alkyl group having 1-5 carbon atoms;
based on the parts by weight of the solid components, the total usage amount of the component (A) cyanate compound having at least two cyanato groups or its pre-polymer and the component (B) active ester is 30-90 parts by weight, wherein the weight ratio between the component (A) cyanate ester compound having at least two cyanato groups or its pre-polymer and the component (B) active ester is 0.2-5: 1.

2. The epoxy resin composition according to claim 1, wherein the component (A) cyanate ester compound having at least two cyanato groups in the molecule or its pre-polymer includes at least one cyanate ester compound having the following structural formula or its pre-polymer: 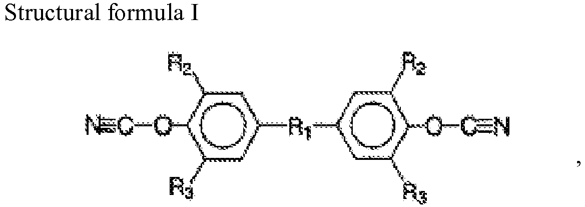 wherein R1 represents, -CH₂-, 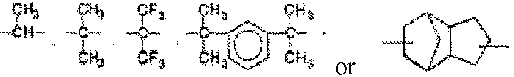 R2 and R3 may be same or different, each represents hydrogen atom or alkyl group having 1 to 4 carbon atoms; 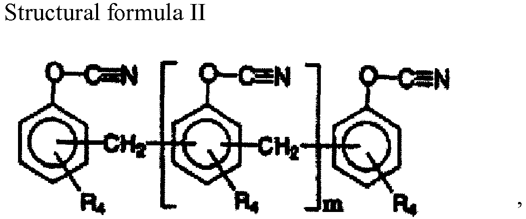 wherein R4 represents hydrogen atom or alkyl group having 1-4 carbon atoms and m is an integer of 1-7.

3. The epoxy resin composition according to claim 1 or 2, wherein the component (A) cyanate ester compound containing at least two cyanato groups in the molecule or its prepolymer is one or more selected from the group consisting of 2,2-bis (4-cyano-phenyl) propane, bis (4-cyano-phenyl)ethane, bis(3,5-dimethy-4-cyanatophenyl)methane, 2,2-bis (4-cyano-phenyl)-1,1,1,3,3,3-hexafluoropropane, α,α'-bis(4-cyano-phenyl)-1,3-bis(isopropyl)benzene, cyclopentadiene cyanate ester, phenol novolac cyanate ester and cresol novolac cyanate ester, or prepolymer thereof.

4. The epoxy resin composition according to claim 3, wherein the component (A) cyanate compound containing at least two cyanato groups in the molecule or its prepolymer is one or more selected from the group consisting of 2,2-bis (4-cyano-phenyl) propane, bis(3,5-dimethy-4-cyanatophenyl)methane and α,α'-bis(4-cyano-phenyl)-1,3-bis(isopropyl)benzene, or prepolymer thereof.

5. The epoxy resin composition according to claim 1, further comprising a flame retardant, wherein the flame retardant is mixed in 5-100 parts by weight based on 100 part by weight of the sum of component (A), component (B) and component (C); the flame retardant is a bromine-containing flame retardant or a non-halogen flame retardant, wherein the bromine-containing flame retardant is selected from the group consisting of decabromodiphenyl ether, decabromodiphenyl ethane, brominated styrene or ethylenebistetrabromophthalimide, and the non-halogen flame retardants is selected from tri(2,6-dimethyphenyl)phosphine, 10-(2,5-dihydroxyphenyl)-9,10-dihydrogen-9-oxa-10-phosphenanthrene-10-oxide, 2,6-bis(2,6-dimethylphenyl) phosphenyl, 10-phenyl-9,10-dihydrogen-9-oxa-10-phosphenanthrene-10-oxide, phenoxy phosphonic cyanide compounds or zinc borate.

6. The epoxy resin composition according to claim 1, further comprising an organic or inorganic filler, wherein the inorganic filler is mixed preferably in 5-1000 parts by weight based on 100 parts by weight of the sum of component (A), component (B) and component (C); the inorganic filler is one or more selected from the group consisting of crystalline silica, fused silica, spherical silica, aluminum nitride, boron nitride, titanium oxide, strontium titanate, barium titanate, alumina, barium sulfate, talc powder, calcium silicate, calcium carbonate, mica, and polytetrafluoroethylene;

7. A high frequency circuit board manufactured by using the epoxy resin composition according to claim 1, comprising several stacked prepregs and copper foils cladded on both sides of the stacked prepregs, wherein the prepregs all include the epoxy resin composition adhering thereon by impregnating and then drying.

8. A high frequency circuit board manufactured according to claim 7, wherein the high frequency circuit board is prepared by cladding the copper coil on both sides of the stacked prepregs and curing in a hot press machine, wherein the curing temperature is 150-250°C and the curing pressure is 25-60 Kg/cm2.

## Patentansprüche

1. Epoxidharzzusammensetzung, umfassend die folgenden festen Komponenten:
(A) Cyanatesterverbindung mit mindestens zwei Cyanatogruppen im Molekül oder dessen Präpolymer,
(B) Aktivester, der einen Aktivester der folgenden Strukturformel umfasst: 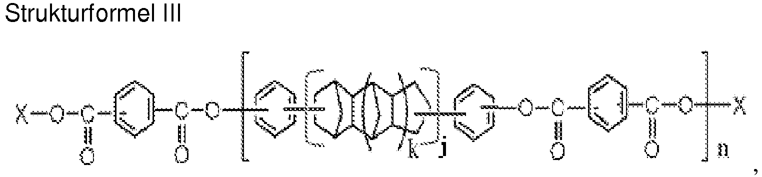 in der
X ein Benzolring oder ein Naphthalinring ist,
j 0 oder 1 ist,
k 0 oder 1 ist,
n die durchschnittliche Wiederholungseinheit darstellt und 0,25-1,25 ist; und
(C) epoxidharzhaltige Naphtholstruktur mit der folgenden Strukturformel 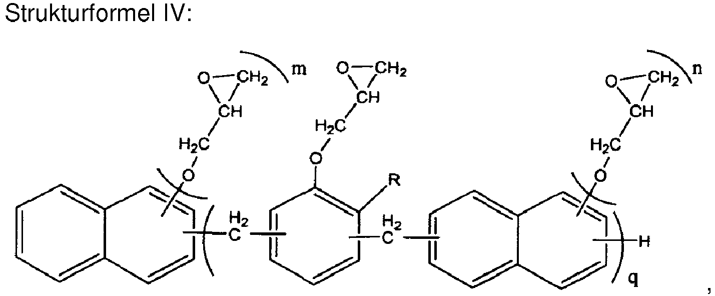
in der m und n jeweils 1 oder 2 sind,
q eine ganze zahl zwischen 1 und 10 ist,
R H oder eine Alkylgruppe mit 1-5 Kohlenstoffatomen ist;
bezogen auf die Gewichtsteile der festen Komponenten, wobei die gesamte Verwendungsmenge der Cyanatverbindung der Komponente (A) mit mindestens zwei Cyanatogruppen oder dessen Präpolymer und des Aktivesters der Komponente (B) 30 bis 90 Gewichtsteile beträgt, wobei das Gewichtsverhältnis zwischen der Cyanatesterverbindung der Komponente (A) mit mindestens zwei Cyanatogruppen oder dessen Präpolymer und dem Aktivester der Komponente (B) 0,2 bis 5:1 beträgt.

2. Epoxidharzzusammensetzung nach Anspruch 1, wobei die Cyanatesterverbindung der Komponente (A) mit mindestens zwei Cyanatogruppen im Molekül oder dessen Präpolymer mindestens eine Cyanatesterverbindung mit der folgenden Strukturformel oder dessen Präpolymer beinhaltet: 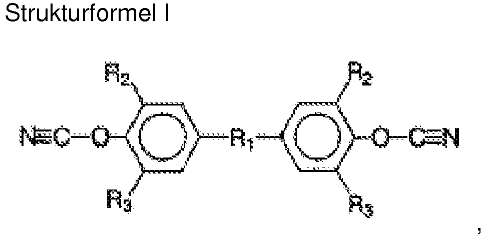 in der R1 für -CH₂- 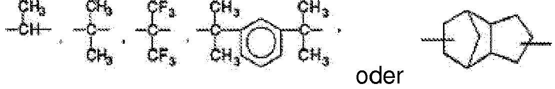 steht, R2 und R3 gleich oder verschieden sein können, wobei jedes für ein Wasserstoffatom oder eine Alkylgruppe mit 1 bis 4 Kohlenstoffatomen steht; 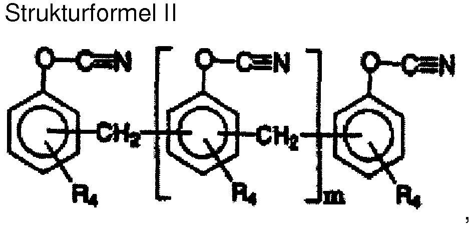 in der R4 für Wasserstoff oder eine Alkylgruppe mit 1-4 Kohlenstoffatomen steht und m eine ganze Zahl von 1-7 ist.

3. Epoxidharzzusammensetzung nach Anspruch 1 oder 2, wobei die Cyanatesterverbindung der Komponente (A) mit mindestens zwei Cyanatogruppen im Molekül oder dessen Präpolymer eine oder mehrere ausgewählt aus der Gruppe bestehend aus 2,2-Bis-(4-cyanophenyl)propan, Bis-(4-cyanophenyl)ethan, Bis-(3,5-dimethyl-4-cyanatophenyl)methan, 2,2-Bis(4-cyanophenyl)-1,1,1,3,3,3-hexafluorpropan, α,α'-Bis-(4-cyanophenyl)-1,3-bis-(isopropyl)benzol, Cyclopentadiencyanatester, Phenolnovolakcyanatester und Cresolnovolakcyanatester oder ein Präpolymer davon ist.

4. Epoxidharzzusammensetzung nach Anspruch 3, wobei die Cyanatverbindung der Komponente (A) mit mindestens zwei Cyanatogruppen im Molekül oder dessen Präpolymer eine oder mehrere ausgewählt aus der Gruppe bestehend aus 2,2-Bis-(4-cyanophenyl)propan, Bis-(3,5-dimethyl-4-cyanatophenyl)methan und α,α'-Bis-(4-cyanophenyl)-1,3-bis-(isopropyl)benzol oder ein Präpolymer davon ist.

5. Epoxidharzzusammensetzung nach Anspruch 1, ferner umfassend ein Flammschutzmittel, wobei das Flammschutzmittel in 5-100 Gewichtsteilen, bezogen auf 100 Gewichtsteile der Summe aus Komponente (A), Komponente (B) und Komponente (C), eingemischt ist; wobei das Flammschutzmittel ein bromhaltiges Flammschutzmittel oder ein halogenfreies Flammschutzmittel ist, wobei das bromhaltige Flammschutzmittel ausgewählt ist aus der Gruppe bestehend aus Decabromdiphenylether, Decabromdiphenylethan, bromiertem Styrol oder Ethylenbistetrabromphthalimid und das halogenfreie Flammschutzmittel ausgewählt ist aus Tri-(2,6-dimethylphenyl)phosphin, 10-(2,5-Dihydroxyphenyl)-9,10-dihydrogen-9-oxa-10-phosphenanthren-10-oxid, 2,6-Bis-(2,6-dimethylphenyl)phosphenyl, 10-Phenyl-9,10-dihydrogen-9-oxa-10-phosphenanthren-10-oxid, Phenoxiphosphonsäurecyanidverbindungen oder Zinkborat.

6. Epoxidharzzusammensetzung nach Anspruch 1, ferner umfassend einen organischen oder anorganischen Füllstoff, wobei der anorganische Füllstoff vorzugsweise in 5-1000 Gewichtsteilen, bezogen auf 100 Gewichtsteile der Summe der Komponente (A), Komponente (B) und Komponente (C), eingemischt ist; wobei der anorganische Füllstoff einer oder mehrere aus der Gruppe bestehend aus kristallinem Siliciumdioxid, Quarzglas, kugelförmigem Siliciumdioxid, Aluminiumnitrid, Bornitrid, Titanoxid, Strontiumtitanat, Bariumtitanat, Aluminiumoxid, Bariumsulfat, Talkumpulver, Calciumsilicat, Calciumcarbonat, Glimmer und Polytetrafluorethylen ist.

7. Hochfrequenzleiterplatte, hergestellt unter Verwendung der Epoxidharzzusammensetzung nach Anspruch 1, umfassend mehrere gestapelte Prepregs und Kupferfolien, die auf beiden Seiten der gestapelten Prepregs aufgebracht sind, wobei alle Prepregs die Epoxidharzzusammensetzung umfassen, die durch Imprägnieren und anschließendem Trocknen daran haftet.

8. Hochfrequenzleiterplatte, hergestellt nach Anspruch 7, wobei die Hochfrequenzleiterplatte durch Aufbringen der Kupferspule auf beide Seiten der gestapelten Prepregs und Härten in einer Heißpressmaschine hergestellt ist, wobei die Härtungstemperatur 150-250°C und der Härtungsdruck 25-60 kg/cm² beträgt.

## Revendications

1. Composition de résine époxy, comprenant les composants solides suivants :
(A) un composé ester de cyanate comportant au moins deux groupes cyanato dans la molécule ou son pré-polymère,
(B) un ester actif, qui comprend un ester actif de formule développée suivante : 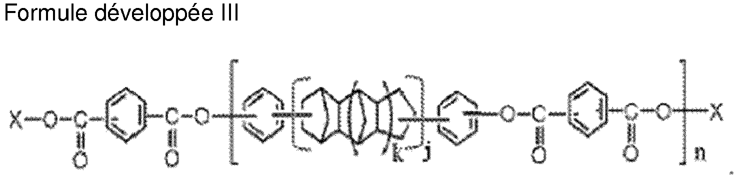 dans laquelle
X est un cycle benzène ou un cycle naphtalène,
j vaut 0 ou 1,
k vaut 0 ou 1,
n signifie le motif répété moyen et vaut 0,25 à 1,25 ; et
(C) une résine époxy contenant une structure naphtol répondant à la formule développée suivante : 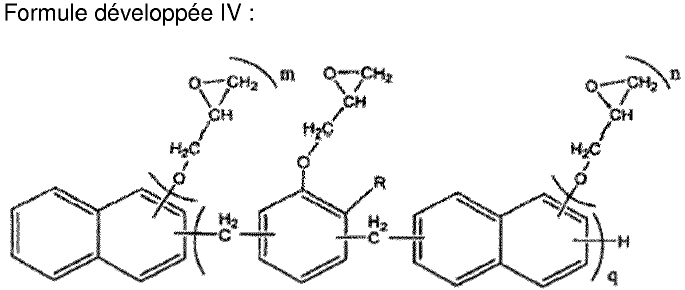
dans laquelle m et n valent 1 ou 2 respectivement,
q est un entier compris entre 1 et 10,
R est H ou un groupe alkyle comportant 1 à 5 atomes de carbone ;
rapporté aux parties en poids des composants solides, la quantité d'utilisation totale du composant (A) composé cyanate comportant au moins deux groupes cyanato ou son pré-polymère et du composant (B) ester actif est de 30 à 90 parties en poids, dans laquelle le rapport en poids entre le composant (A) composé ester de cyanate comportant au moins deux groupes cyanato ou son pré-polymère et le composant (B) ester actif est de 0,2 à 5:1.

2. Composition de résine époxy selon la revendication 1, dans laquelle le composant (A) composé ester de cyanate comportant au moins deux groupes cyanato dans la molécule ou son pré-polymère inclut au moins un composé ester de cyanate répondant à la formule développée suivante ou son pré-polymère : 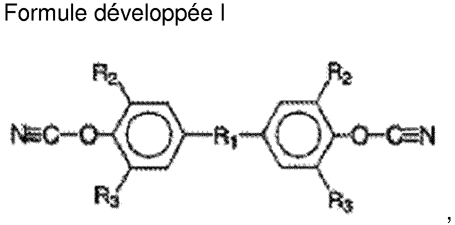 dans laquelle R1 représente,-CH₂-, 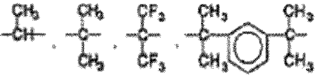 ou 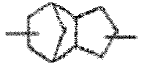 R2 et R3 peuvent être identiques ou différents, chacun représente un atome d'hydrogène ou un groupe alkyle comportant 1 à 4 atomes de carbone ; 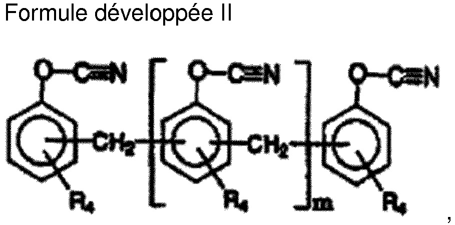 dans laquelle R4 représente un atome d'hydrogène ou un groupe alkyle comportant 1 à 4 atomes de carbone et m est un entier de 1 à 7.

3. Composition de résine époxy selon la revendication 1 ou 2, dans laquelle le composant (A) composé ester de cyanate contenant au moins deux groupes cyanato dans la molécule ou son pré-polymère est un ou plusieurs éléments choisis dans le groupe consistant en le 2,2-bis(4-cyano-phényl) propane, le bis (4-cyano-phényl)éthane, le bis(3,5-diméthy-4-cyanatophényl)méthane, le 2,2-bis (4-cyano-phényl)-1,1,1,3,3,3-hexafluoropropane, le α-α'-bis(4-cyano-phényl)-1,3-bis(isopropyl)benzène, l'ester de cyclopentadiène cyanate, un ester de phénol novolaque cyanate et un ester de crésol novolaque cyanate, ou un pré-polymère de ceux-ci.

4. Composition de résine époxy selon la revendication 3, dans laquelle le composant (A) composé de cyanate contenant au moins deux groupes cyanato dans la molécule ou son pré-polymère est un ou plusieurs éléments choisis dans le groupe consistant en le 2,2-bis(4-cyano-phényl)propane, le bis(3,5-diméthy-4-cyanatophényl)méthane et le α-α'-bis(4-cyano-phényl)-1,3-bis(isopropyl)benzène, ou un pré-polymère de ceux-ci.

5. Composition de résine époxy selon la revendication 1, comprenant en outre un agent ignifuge, dans laquelle l'agent ignifuge est mélangé à hauteur de 5 à 100 parties en poids rapporté à 100 parties en poids de la somme du composant (A), du composant (B) et du composant (C) ; l'agent ignifuge est un agent ignifuge contenant du brome ou un agent ignifuge non halogéné, dans lequel l'agent ignifuge contenant du brome est choisi dans le groupe consistant en le décabromodiphényl éther, le décabromodiphényl éthane, le styrène bromé ou l'éthylènebistétrabromophtalimide, et l'agent ignifuge non-halogéné est choisi parmi la tri(2,6-diméthylphényl)phosphine, le 10-(2,5-dihydroxyphényl)-9,10-dihydrogén-9-oxa-10-phosphénanthrène-10-oxyde, le 2,6-bis(2,6-diméthylphényl)phosphényle, le 10-phényl-9,10-dihydrogén-9-oxa-10-phosphénanthrène-10-oxyde, des composés cyanure phénoxy phosphonique ou le borate de zinc.

6. Composition de résine époxy selon la revendication 1, comprenant en outre une charge organique ou inorganique, dans laquelle la charge inorganique est mélangée de préférence à hauteur de 5 à 1000 parties en poids rapporté à 100 parties en poids de la somme du composant (A), du composant (B) et du composant (C) ; la charge inorganique est un ou plusieurs éléments choisis dans le groupe consistant en la silice cristalline, la silice fondue, la silice ferrique, le nitrure d'aluminium, le nitrure de bore, l'oxyde de titane, le titanate de strontium, le titanate de baryum, l'alumine, le sulfate de baryum, la poudre de talc, le silicate de calcium, le carbonate de calcium, le mica et le polytétrafluoroéthylène.

7. Carte de circuit haute fréquence fabriquée par l'utilisation de la composition de résine époxy selon la revendication 1, comprenant plusieurs préimprégnés empilés et des feuilles de cuivre plaquées des deux côtés des préimprégnés empilés, dans laquelle les préimprégnés incluent tous la composition de résine époxy collant dessus par imprégnation puis séchage.

8. Carte de circuit haute fréquence fabriquée selon la revendication 7, dans laquelle la carte de circuit haute fréquence est préparée par plaquage de la bobine de cuivre des deux côtés des préimprégnés empilés et durcissement dans une presse à chaud, dans laquelle la température du durcissement est de 150 à 250 °C et la pression de durcissement est de 25 à 60 Kg/cm².
